# EUROPÄISCHE PATENTANMELDUNG

(11) **EP 2 315 041 A2**
(43) Veröffentlichungstag der Anmeldung: **27.04.2011**
(21) Anmeldenummer: 10013851.0
(22) Anmeldetag: 21.10.2010
(51) Int. Cl.: G01R 22/06

(54) **Elektronischer Stromzähler**

(30) Priorität: 24.10.2009 DE 102009050606; 11.11.2009 DE 102009052507
(71) Anmelder: Hager Electro GmbH & Co. KG, 66440 Blieskastel (DE)
(72) Erfinder: Hauck, Johannes, 66440 Blieskastel (DE)
(74) Vertreter: Bernhardt, Reinold

(57) **Zusammenfassung**

Die Erfindung betrifft einen elektronischen Stromzähler (1) mit einem isolierenden Gehäuse (2). Erfindungsgemäß sind Einrichtungen zur elektrischen und mechanischen Ankopplung eines Zusatzgerätes (8) an den Stromzähler (1) unmittelbar angrenzend an das Gehäuse (2) vorgesehen. Vorzugsweise weist das Gehäuse (2) einen Schacht (9) für die Aufnahme wenigstens eines Teils des Zusatzgerätes (8) auf.

## Beschreibung

Die Erfindung betrifft einen elektronischen Stromzähler für die Elektroinstallation von Gebäuden.

Elektronische Stromzähler werden zunehmend anstelle herkömmlicher, elektromechanischer Stromzähler eingesetzt. Durch Einsatz geeigneter Adapter lassen sich zur Installation der elektronischen Stromzähler die für die herkömmlichen Stromzähler verwendeten Zähleranschlussplätze nutzen.

Die DE 102 61 206 B4 beschreibt einen solchen Adapter, der neben einem elektronischen Stromzähler auf einer Hutprofilträgerschiene montierte Zusatzgeräte aufnehmen kann, die z.B. der Kommunikation mit dem Stromversorgungsuntemehmen dienen.

Der vorliegenden Erfindung liegt die Aufgabe zugrunde, den Funktionsumfang elektronische Stromzähler verwendender Zähleranschiussplatzinstallationen zu erweitern.

Diese Aufgabe wird durch einen neuen elektronischen Stromzähler gelöst, der gekennzeichnet ist durch Einrichtungen zur elektrischen und mechanischen Ankopplung eines Zusatzgerätes an den Stromzähler unmittelbar angrenzend an sein Gehäuse.

Gemäß der Erfindung wird der elektronische Stromzähler unmittelbar mit dem Zusatzgerät z.B. unter Herstellung einer Steckverbindung zwischen dem Stromzählergehäuse und dem Gehäuse des Zusatzgerätes verbunden. Das Zusatzgerät kann z.B. der Kommunikation mit dem zuständigen Stromversorgungsuntemehmen dienen, während ein weiteres, von dem Stromzähler getrennt installiertes Zusatzgerät, das an den Stromzähler über eine Kabel- oder Funkverbindung angeschlossen ist, z.B. in Kommunikationsverbindung mit anderen Stromanbietern steht.

Das zuständige Stromversorgungsunternehmen kann über das Zusatzgerät insbesondere eine Fernauslesung des elektronischen Stromzählers durchführen. Gegebenenfalls kann über das Zusatzgerät auch ferngesteuert eine Stilllegung der Anschlussplatzinstallation durch das Stromversorgungsunternehmen erfolgen.

In einer besonders bevorzugten Ausführungsform der Erfindung weist das Stromzählergehäuse einen Schacht für die Aufnahme wenigstens eines Teils des Zusatzgerätes auf. In diesem, insbesondere an die Gehäuseform des Zusatzgerätes angepassten Schacht kann das Zusatzgerät eingesteckt werden, wobei im Schacht angeordnete Anschlusskontakte des Stromzählers den elektrischen Kontakt mit entsprechenden Anschlusskontakten des Zusatzgerätes herstellen.

Vorzugsweise sind die Anschlusskontakte des Stromzählers oder/und die Anschlusskontakte des Zusatzgerätes bei Einführung des Zusatzgerätes in den Aufnahmeschacht elastisch abbiegbar.

Das Zusatzgerät braucht nicht voll in den Aufnahmeschacht hinein versenkbar zu sein, sondern kann unter Einsparung von innerhalb des Stromzählergehäuses benötigtem Bauraum von dem Stromzählergehäuse vorstehen.

Der Aufnahmeschacht und das Gehäuse des Zusatzgeräts sind zweckmäßig so gestaltet, dass ein vollständiges Einschieben des Zusatzgerätes in den Aufnahmeschacht nur in der für die Herstellung der elektrischen Anschlussverbindung richtigen Stellung möglich ist.

Zweckmäßig ist das Zusatzgerät an dem Stromzähler einrastbar, so dass zu seiner Befestigung am Stromzähler keinerlei Werkzeug erforderlich ist.

Der Aufnahmeschacht öffnet zweckmäßig zur Vorderseite des Stromzählergehäuses hin. Eine Schachtöffnung in einer Gehäuseseitenwand wäre ebenfalls möglich.

Zweckmäßig ist eine bei Nichtbenutzung des Zusatzgerätes verwendbare Abdeckung für den Aufnahmeschacht vorgesehen.

Ferner kann ein das Zusatzgerät in der Ankopplungsposition sichernder, vorzugsweise plombierbarer Verschluss vorhanden sein. Gegebenenfalls ist dieser Verschluss gemeinsam mit dem Stromzähler in dessen Anschlussposition plombierbar.

In den Stromzähler kann ferner eine Antenne integriert sein, insbesondere in die Gehäusewand des Stromzählers, über die das Zusatzgerät in Verbindung mit einem zellularen Funknetz bzw. Handynetz treten kann.

Zweckmäßig ist der Stromzähler, vorzugsweise über eine Kabelverbindung, mit einem weiteren, zu dem Stromzähler im Abstand angeordneten Zusatzgerät verbindbar, wobei dieses Zusatzgerät in Bezug auf die Hardware baugleich mit dem an den Stromzähler koppelbaren Zusatzgerät sein kann und mit einem universell verwendbaren Anschlussrahmen koppelbar ist.

Die Erfindung wird nachfolgend anhand von Ausführungsbeispielen und der beiliegenden, sich auf diese Ausführungsbeispiele beziehenden Zeichnungen näher erläutert. Es zeigen:
- Fig. 1: einen erfindungsgemäßen elektronischen Stromzähler in einer Draufsicht,
- Fig. 2: den Stromzähler von Fig. 1 in einer Seitenansicht,
- Fig. 3: ein an den Stromzähler von Fig. 1 und 2 gekoppeltes Zusatzgerät,
- Fig. 4: den Stromzähler von Fig. 1 in einer Teilansicht ohne Zusatzgerät,
- Fig. 5: eine Zähleranschiussplatzinstallation mit einem elektronischen Stromzähler gemäß Fig. 1 bis 4 und einem weiteren, von dem Stromzähler getrennt auf einer Hutprofilträgerschiene montierten Zusatzgerät,
- Fig. 6: eine Zähleranschlussplatzinstallation für einen mit Zusatzgeräten betriebenen elektronischen Stromzähler gemäß einem weiteren Ausführungsbeispiel, und
- Fig. 7: verschiedene Möglichkeiten zur Kombination des Stromzählers von Fig. 6 mit Zusatzgeräten.

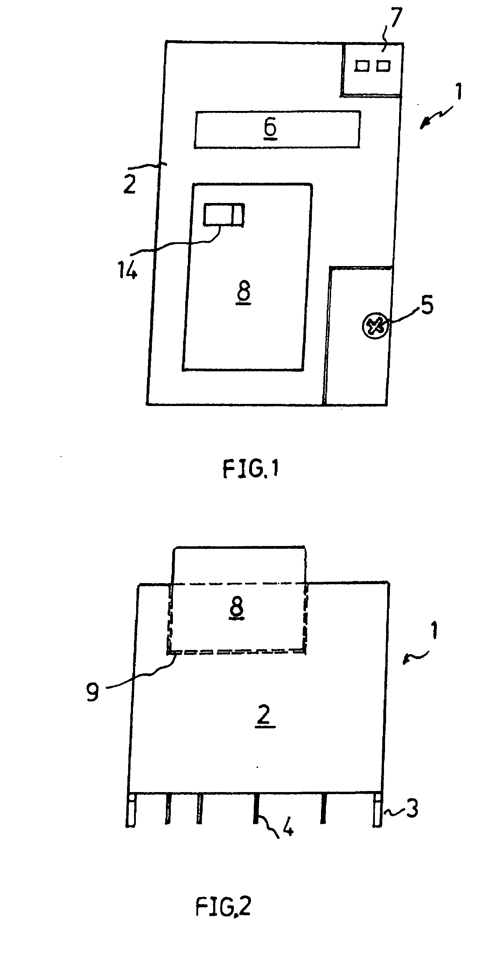

Ein elektronischer Stromzähler 1 weist ein etwa quaderförmiges Gehäuse 2 aus einem isolierenden Material auf. Von der Gehäuserückseite erstrecken sich vier, mit dem Gehäuse einstückig verbundene Haken 3 und insgesamt sieben Anschlusskontakte 4 für drei Stromphasen und den Neutralleiter. In Fig. 2 sind zwei der Haken und vier von den Anschlusskontakten sichtbar. Zur Ankopplung des Stromzählers an eine Tragplatte eines Installationsplatzes wird der Zähler mit der Rückseite voran auf die Tragplatte aufgesetzt, die für die Haken und Anschlusskontakte entsprechende Aufnahmeschlitze aufweist. Durch Verschiebung des Stromzählers auf der Tragplatte kommen die Anschlusskontakte 4 in Verbindung mit entsprechenden, hinter der Tragplatte angeordneten Anschlussstücken, während die Haken 3 für eine mechanische Ankopplung an die Tragplatte sorgen.

In der Anschlussstellung lässt sich der Stromzähler 1 durch einen drehbaren Bolzen 5 arretieren. Der das gesamte Zählergehäuse durchsetzende Bolzen wird zur Arretierung in eine Öffnung in der Zählertragplatte eingedreht und kann durch nicht gezeigte Einrichtungen in dieser Drehstellung plombiert werden.

Die in Fig. 1 sichtbare Vorderseite des Stromzählers 1 weist ein Anzeigefeld 6 auf, insbesondere für die Anzeige des Stromverbrauchs. Ferner ist an der Stromzählervorderseite eine opto-elektronische Schnittstelle 7 zur Nutzung durch den Stromverbraucher vorgesehen.

Das Bezugszeichen 8 verweist auf ein Zusatzgerät, das in dem gezeigten Ausführungsbeispiel der Kommunikation mit dem Stromversorgungsunternehmen dient und über das z.B. eine Fernauslesung des Stromzählers durch das Stromversorgungsunternehmen erfolgen kann. Das Zusatzgerät 8 lässt sich unter Einführung in einen Aufnahmeschacht 9 auf den Stromzähler 1 aufstecken und am Stromzähler durch (nicht gezeigte) Rasteinrichtungen befestigen. In dem gezeigten Ausführungsbeispiel öffnet der Aufnahmeschacht 9 zur Gehäusevorderseite. Es wäre auch möglich, einen seitlich öffnenden Aufnahmeschacht oder am Rand des Stromzählergehäuses eine das Zusatzgerät aufnehmende Stufenausnehmung vorzusehen.

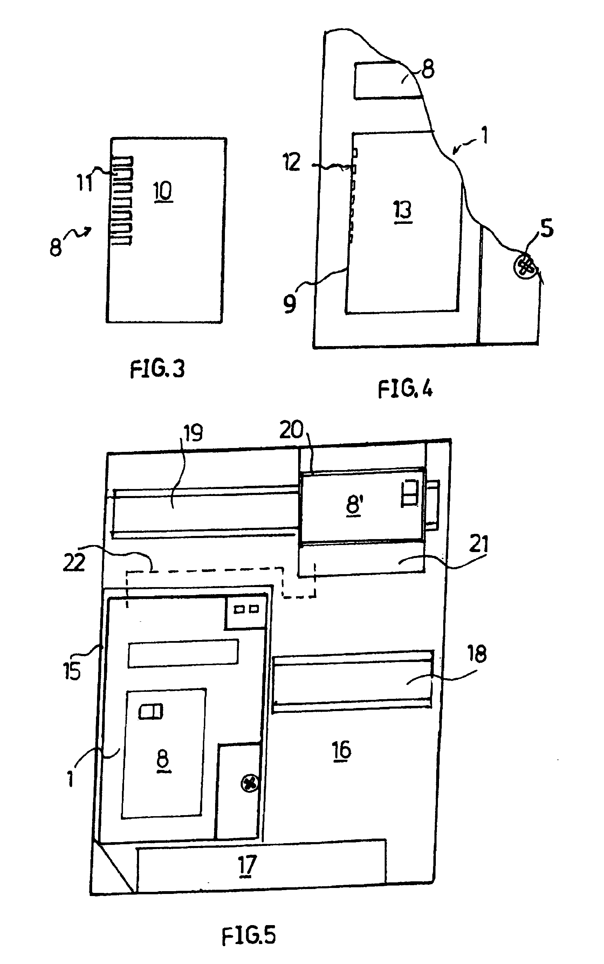

Das Zusatzgerät 8 weist ein etwa quaderförmiges Gehäuse 10 aus isolierendem Material auf. Wie Fig. 3 erkennen lässt, sind am unteren Gehäuserand Anschlusskontakte 11 zur elektrischen Verbindung mit dem Stromzähler 1 vorgesehen. Den Anschlusskontakten 11 entsprechende Anschlusskontakte 12 des Stromzählers 1 sind angrenzend an den Boden 13 des Aufnahmeschachts 9 angeordnet, wie Fig. 4 erkennen lässt. Die Anschlusskontakte 12 stehen in den Schacht 9 hinein vor und sind beim Einschieben des Zusatzgeräte 8 elastisch abbiegbar.

Das Zusatzgerät 8 weist in dem gezeigten Ausführungsbeispiel ferner eine für den Stromverbraucher nutzbare Schnittstelle 14 zum Anschluss des Zusatzgerätes an einen Personalcomputer auf.

Wie Fig. 2 erkennen lässt, steht das elektrisch und mechanisch mit dem Stromzählers 1 verbundene Zusatzgerät 8 von der Vorderseite des Stromzählergehäuses vor. Der für das Zusatzgerät innerhalb des Stromzählergehäuses benötigte Platz ist dadurch verringert. Zum Beispiel an den Seitenwänden im überstehenden Bereich könnten weitere, durch den Stromverbraucher oder/und das Stromversorgungsunternehmen nutzbare Anschlüsse vorgesehen sein. Solche Anschlüsse könnten auch der Verbindung mit weiteren, an der Zähleranschlussinstallation vorgesehenen Zusatzgeräten dienen.

Das elektrisch und mechanisch mit dem Stromzähler verbundene Zusatzgerät 8 und der Aufnahmeschacht 9 sind so gestaltet, dass das Zusatzgerät 8 nur in der richtigen Montagestellung bis in die Anschlussposition in den Schacht 9 eingebracht werden kann.

Für den Betrieb des Stromzählers 1 ohne das Zusatzgerät 8 steht eine (nicht gezeigte), ggf. plombierbare Abdeckung für den Aufnahmeschacht 9 zur Verfügung.

Es wird nun auf Fig. 5 Bezug genommen, die den vorangehend beschriebenen, mit dem Zusatzgerät 8 versehenen Stromzähler 1 montiert auf einer Zählertragplatte 15 zeigt. Die Zählertragplatte 15 ist Bestandteil eines eine Grundplatte 16 aufweisenden Adapters, der sich am Zählerkreuz eines Zähleranschlussplatzes für einen herkömmlichen elektro-mechanischen Stromzähler befestigen lässt.

Neben einer Kabelanschlussleiste 17 umfasst der Adapter auf der Grundplatte 16 angebrachte Hutprofilträgerschienen 18 und 19 für die Aufnahme von weiteren Zusatzgeräten.

Fig. 5 zeigt beispielhaft ein Zusatzgerät 8', dessen Hardware in dem gezeigten Ausführungsbeispiel identisch zu dem Zusatzgerät 8 ist. Das Zusatzgerät 8' ist mit einem einen Aufnahmeschacht 20 bildenden Anschlussrahmen 21 verbunden, der universell für unterschiedliche, ggf. nur unterschiedlich programmierte, Zusatzgeräte 8' einsetzbar ist. Bestehende Verdrahtungen zwischen dem Anschlussrahmen 21 und dem Stromzähler 1 oder/und weiteren Zusatzgeräten bleiben von einem solchen Austausch unberührt. Der Rahmen 21 ist in der hier einbezogenen deutschen Patentanmeldung 10 2008 063 878.1 des Anmelders beschrieben.

In dem vorliegenden Ausführungsbeispiel besteht zwischen dem Stromzähler 1 und dem weiteren Zusatzgerät 8', das weitere Kommunikationsaufgaben übernehmen kann, über den Rahmen 21 eine durch eine Strichlinie 22 angedeutete Leitungsverbindung.

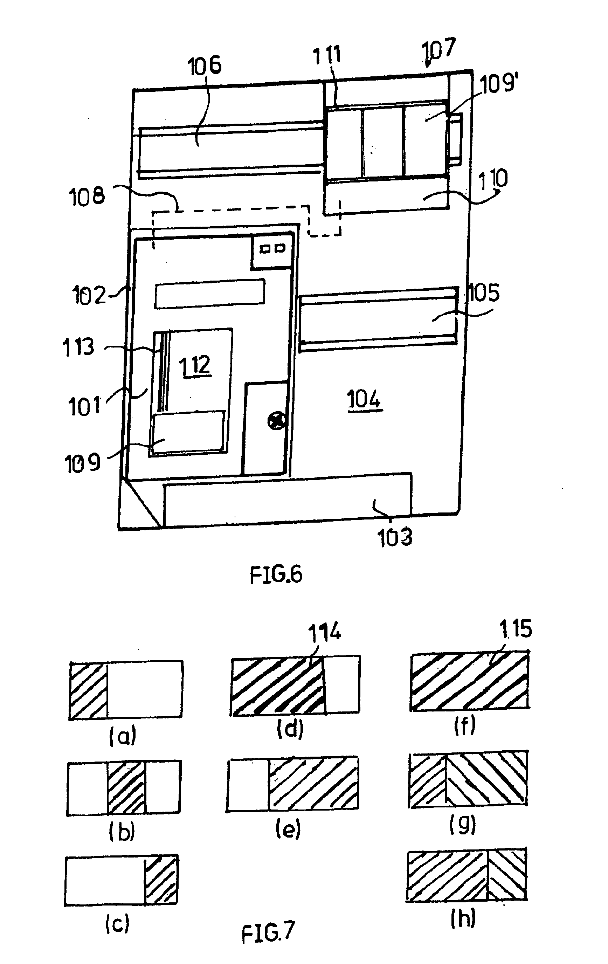

Es wird nachfolgend auf die Fig. 6 und 7 Bezug genommen.

Eine Zähleranschlussplatzinstallation für einen elektronischen Stromzähler 101 umfasst eine Zählertragplatte 102. Bei der Zähleranschlussplatzinstallation handelt es sich um einen Adapter, der sich am Zählerkreuz eines Zähleranschlussplatzes für einen herkömmlichen elektro-mechanischen Stromzähler befestigen lässt. Neben einer Kabelanschlussleiste 103 umfasst der Adapter auf einer Grundplatte 104 angebrachte Hutprofilträgerschienen 105 und 106 für die Aufnahme von Zusatzgeräten.

Fig. 6 zeigt beispielhaft ein auf der Hutprofilträgerschiene 106 montiertes Zusatzgerät 107. Zwischen dem Zusatzgerät 107 und dem elektronischen Stromzähler 101 besteht eine Leitungsverbindung 108. Ein weiteres Zusatzgerät mit einem Zusatzgeratemodul 109 ist unmittelbar mit dem Stromzähler 101 verbunden.

Das auf der Trägerschiene 106 montierte Zusatzgerät 107 umfasst einen Sockelteil 110, der einen Aufnahmeschacht 111 bildet, in den in dem betrachteten Beispiel drei Zusatzgerätemodule 109' unter elektrischer und mechanischer Verbindung mit dem Sockelteil 110 eingesteckt sind. Die mit dem Zusatzgerätemodul 109 äußerlich baugleichen Zusatzgerätemodule 109' sind in dem Aufnahmeschacht 111 durch nicht gezeigte Teile geführt und eingerastet.

Kabelanschlüsse und sonstige Elemente zur Verbindung des Zusatzgerätes 107 mit dem elektronischen Stromzähler 101 und anderen Einrichtungen sind allein am Sockelteil 110 vorgesehen. Vorteilhaft brauchen beim Austausch von Zusatzgerätemodulen 109' keine derartigen Verbindungen gelöst oder neu hergestellt zu werden.

Der unmittelbar mit dem Stromzähler 101 verbundene Zusatzgerötemodul 109 ist in einen im Stromzähler 101 gebildeten Aufnahmeschacht 112 eingesteckt, wo er wie die Anschlusselemente 109' geführt und eingerastet ist. Am Boden des Aufnahmeschachts 112 befinden sich Kontaktschienen 113, über die der Zusatzgerätemodul 109 und zwei weitere dem Zusatzgerätemodul 109 entsprechende Module elektrisch mit dem Stromzähler verbindbar sind.

Entsprechende Kontaktschienen zur elektrischen Verbindung der Zusatzgerätemodule mit dem Sockelteil 110 weist auch der Aufnahmeschacht 111 des Zusatzgerätes 107auf. Den oben genannten Anschluss- und Verbindungselementen des Sockelteils 110 entsprechende Elemente, die mit den Kontaktschienen 113 in Verbindung stehen, sind unmittelbar in den Stromzähler integriert, d.h. der Stromzähler selbst bildet den Sockelteil des Zusatzgeräte.

Der Sockelteil 110 und der einen Sockelteil bildende Stromzähler 101 sind in den hier einbezogenen deutschen Patentanmeldungen 10 2008 063 878.1 und 10 2009 050 606.3 des Anmelders beschrieben.

Fig. 7 zeigt weitere Möglichkeiten für die Bestückung des Aufnahmeschachts 111 bzw. 112 mit Zusatzgerätemodulen.

Fig. 7a entspricht der Stellung des in Fig. 6 gezeigten Zusatzgerätemoduls 109 inner halb des Aufnahmeschachts 112. Fig. 7b und c zeigen zwei weitere mögliche Steckpositionen dieses Zusatzgerätemoduls.

Gemäß Fig. 7d und e ist in den Aufnahmeschacht 111 bzw. 112 ein zwei Steckplätze ausfüllender Zusatzgerätemodul 114 in zwei möglichen Stellungen einsteckbar.

Fig. 7f zeigt einen den Aufnahmeschacht 111 bzw. 112 vollständig ausfüllenden Zusatzgerätemodul 115.

Fig. 7g und h zeigen Kombinationen aus den Zusatzgerätemodulen 109 und 114 in den beiden möglichen Steckpositionen.

Der den gesamten Aufnahmeschacht ausfallende Vollmodul 115 kann ggf. zur Bildung eines mehreren Stromzählern gemeinsamen Zusatzgerätes dienen.

## Patentansprüche

1. Elektronischer Stromzähler (1) mit einem isolierenden Gehäuse (2),
**gekennzeichnet durch** Einrichtungen (9,12) zur elektrischen und mechanischen Ankopplung eines Zusatzgerätes (8) an den Stromzähler (1) unmittelbar angrenzend an das Gehäuse (2).

2. Stromzähler nach Anspruch 1,
**dadurch gekennzeichnet,**
**dass** zwischen dem Stromzähler (1) und dem Zusatzgerät (8) eine Steckverbindung herstellbar ist.

3. Stromzähler nach Anspruch 1 oder 2,
**dadurch gekennzeichnet,**
**dass** das Gehäuse (2) einen Schacht (9) für die Aufnahme wenigstens eines Teils des Zusatzgerätes (8) aufweist.

4. Stromzähler nach einem der Ansprüche 1 bis 3,
**dadurch gekennzeichnet,**
**dass** das Zusatzgerät (8) an dem Stromzähler (1) einrastbar ist.

5. Stromzähler nach Anspruch 4,
**dadurch gekennzeichnet,**
**dass** in den Schacht (9) hinein Anschlusskontakte (12) des Stromzählers (1) zur Verbindung mit entsprechend angeordneten Anschlusskontakten (11) des Zusatzgerätes (8) vorstehen.

6. Stromzähler nach Anspruch 5,
**dadurch gekennzeichnet,**
**dass** die Anschlusskontakte (12) des Stromzählers (1) oder/und die Anschlusskontakte (11) des Zusatzgerätes (8) bei Einführung des Zusatzgerätes (8) in den Aufnahmeschacht (9) elastisch abbiegbar sind.

7. Stromzähler nach einem der Ansprüche 1 bis 6,
**dadurch gekennzeichnet,**
**dass** eine bei Nichtbenutzung des Zusatzgerätes (8) verwendbare Abdeckung für den Aufnahmeschacht (9) vorgesehen ist.

8. Stromzähler nach einem der Ansprüche 1 bis 7,
**dadurch gekennzeichnet,**
**dass** ein das Zusatzgerät (8) in der Ankopplungsposition sichernder, vorzugsweise plombierbarer, Verschluss vorgesehen ist.

9. Stromzähler nach Anspruch 8,
**dadurch gekennzeichnet,**
**dass** der Verschluss gemeinsam mit dem Stromzähler (1) in dessen Anschlussposition plombierbar ist.

10. Stromzähler nach einem der Ansprüche 1 bis 9,
**dadurch gekennzeichnet,**
**dass** das Zusatzgerät ein Kommunikationsgerät umfasst, insbesondere zur Kommunikation mit dem Stromversorgungsunternehmen.

11. Stromzähler nach Anspruch 10,
**dadurch gekennzeichnet,**
**dass** das Kommunikationsgerät (9) im Zuge der Ankopplung an den Stromzähler (1) mit einer in den Stromzähler (1), insbesondere dessen Gehäuse (2) integrierten Antenne verbindbar ist.

12. Stromzähler nach einem der Ansprüche 1 bis 11,
**dadurch gekennzeichnet,**
**dass** der Stromzähler (1) vorzugsweise über eine Kabelverbindung (22), mit einem weiteren, zu dem Stromzähler (1) im Abstand angeordneten Zusatzgerät (8') verbindbar ist.

13. Stromzähler nach einem der Ansprüche 1 bis 12,
**dadurch gekennzeichnet,**
**dass** an den Stromzähler (101) wahlweise unterschiedliche Zusatzgerätemodule (114,115) oder/und Zusatzgerätemodule (109,109') in unterschiedlicher Anzahl koppelbar sind.

14. Stromzähler nach Anspruch 13,
**dadurch gekennzeichnet,**
**dass** der Stromzähler einen Sitz (112) zur Aufnahme von maximal drei oder mehr als drei Zusatzgerätemodulen (109') aufweist.

15. Stromzähler nach Anspruch 14,
**dadurch gekennzeichnet,**
**dass** der Sitz (112) als die Zusatzgerätemodule (109,114,115) aufnehmender Schacht (112) ausgebildet ist.
